# EUROPEAN PATENT APPLICATION

(11) **EP 1 109 196 A1**
(43) Date of publication of application: **20.06.2001**
(21) Application number: 00310618.4
(22) Date of filing: 30.11.2000
(51) Int. Cl.: H01J 37/09, H01J 37/317, H01J 37/04

(54) **Diamond-like coated components in an ion implanter for reducing x-ray emissions**

(30) Priority: 13.12.1999 US 460367
(71) Applicant: Axcelis Technologies, Inc., Beverly, MA 01915 (US)
(72) Inventor: McIntyre, Edward Kirby, Norfolk, MA 02038 (US); Allen, Ernest Everett, Essex, MA 01966 (US); Jones, Mary Alice, Essex, MA 01915 (US); Nakatsugawa, Tomoya, Middlesex, Massachusetts 01965 (US)
(74) Representative: Burke, Steven David

(57) **Abstract**

A component of an ion implanter (10), and a method of operating same, are provided for reducing the amount of x-rays generated when an ion beam (15) passes therethrough. In one embodiment, the component comprises an electrode (72) in an ion implanter radio frequency (RF) linear accelerator (linac) (18) that is coated with a material coating (114) having as lesser atomic mass that that of the underlying electrode, such that electrons impacting said coating produce less x-rays than electrons impacting said electrode. The electrode (72) may be made of aluminum, and the coating (114) may be made of a carbon-based material, such as a synthetic diamond or a diamond-like coating (DLC) material. The coating (114) has a thickness of approximately two to ten (2-10) microns (µm), and is applied by a chemical vapor deposition (CVD) process.

## Description

### Field of the Invention

The present invention relates generally to ion implantation systems and more particularly to the use of diamond or diamond-like coated components in an ion implanter for reducing x-ray emissions.

### Background of the Invention

Ion implantation has become the technology preferred by industry to dope semiconductors with impurities in the large-scale manufacture of integrated circuits. High-energy ion implanters are used for deep implants into a substrate. Such deep implants are required to create, for example, retrograde wells. Eaton GSD/HE and GSD/VHE ion implanters are examples of such high-energy implanters. These implanters can provide ion beams at energy levels up to 5 MeV (million electron volts). U.S. Patent No. 4,667,111, assigned to the assignee of the present invention, Eaton Corporation, describes such a high-energy ion implanter.

Ion implanters, especially high-energy ion implanters, emit unintended ionizing radiation in the form of x-rays if accelerated stray electrons strike atoms of gases and/or implanter structure. Such electron generated x-rays can occur any place in the beamline where fast electrons collide with either atoms within the residual gas or those that form structural components of the beamline. Electrodes that accelerate (and decelerate) ions within an ion beam in an ion implanter, by means of electrical fields that affect the progress of the ions, are one specific example of ion implanter components that can cause x-ray emission.

In a high-energy ion implanter, the ion beam accelerates as it passes through a radio frequency (RF) linear accelerator (linac). The ion beam progresses through the RF linac by passing through a series of acceleration stages (resonator modules) in which accelerating fields are produced by synchronizing the frequency of the RF voltage to the ion beam velocity. Beam transmission through RF acceleration electrodes is usually inefficient, resulting in many secondary electrons produced by beam collisions along the structure. Such electrons can be high radiation producers.

These electrons that pass through the linac sometimes impact the resonator accelerating electrodes. Bremsstrahlung is the process of producing electromagnetic radiation (*e.g.*, x-rays) when a fast charged particle such as an electron is deflected by another charged particle or component such as an electrode. During the Bremsstrahlung process, an electron can give up any amount of energy ranging from near zero to its maximum kinetic energy. The resulting radiation has a continuous spectrum that extends into the x-ray range. In high-energy ion implanters, a commonly occurring form of such radiation is the acceleration of secondary electrons that impact and are deflected by the linac resonator electrodes.

Typically, in ion implanters, the area around a linac must be lined with lead or other x-ray absorptive material. The preferred method is to attach it permanently to the appropriate implanter structure. For the most efficient utilization of shielding material, it should be located as close as possible to the origin of the radiation. Although such a shielding process is effective in preventing x-rays from escaping the implanter enclosure, such shielding adds weight and expense to the implanter.

It is known to coat electrodes or other components of an ion implanter with materials to facilitate cleaning and to minimize contamination. For example, U.S. Patent No. 5,952,060 uses diamond-like coatings for the process chamber walls or components therein to resist etching. Similarly, U.S. Patent No. 5,916,370 discloses the use of diamond-like coatings on a wafer pedestal to resist etching because such a coating is inert to most etchants. However, such coatings have heretofore not been applied to an RF linac electrode, or other implanter structural component, to reduce x-ray generation.

It is an object of the present invention, then, to provide ion implanter components that reduce the emissions of x-rays due to the Bremsstrahlung effect. It is another object of the invention to provide such components in the form of electrodes that are used to accelerate and decelerate the ion beam. It is yet a further object to provide such electrodes in the RF linear accelerator portion of a high-energy ion implanter.

### Summary of the Invention

A component of an ion implanter, and a method of operating same, are provided for reducing the amount of x-rays generated when an ion beam passes therethrough. In one embodiment, the component comprises an electrode in an ion implanter radio frequency (RF) linear accelerator (linac) that is coated with a material coating having as lesser atomic mass that that of the underlying electrode, such that electrons impacting the coating produce less x-rays than electrons impacting the electrode. The electrode may be made of aluminum, and the coating may be made of a carbon-based material, such as a synthetic diamond or a diamond-like coating (DLC) material. The coating has a thickness of approximately two to ten (2-10) microns (µm), and is applied by a chemical vapor deposition (CVD) process.

### Brief Description of the Drawings

Figure 1 is a schematic block diagram of a high-energy ion implanter into which is incorporated the present invention for reducing x-ray emissions;
Figure 2 shows a cross sectional view of one of a plurality of resonator modules that make up the linear accelerator portion of the ion implanter of Figure 1;
Figure 3 is a more detailed, cross sectional view of the accelerating electrode of the resonator module of Figure 2;
Figure 4 is a sectional view of the electrode of Figure 3 taken along the lines 4-4 of Figure 3; and
Figure 5 is a sectional view of the electrode of Figure 3 taken along the lines 5-5 of Figure 4.

### Detailed Description of a Preferred Embodiment of the Invention

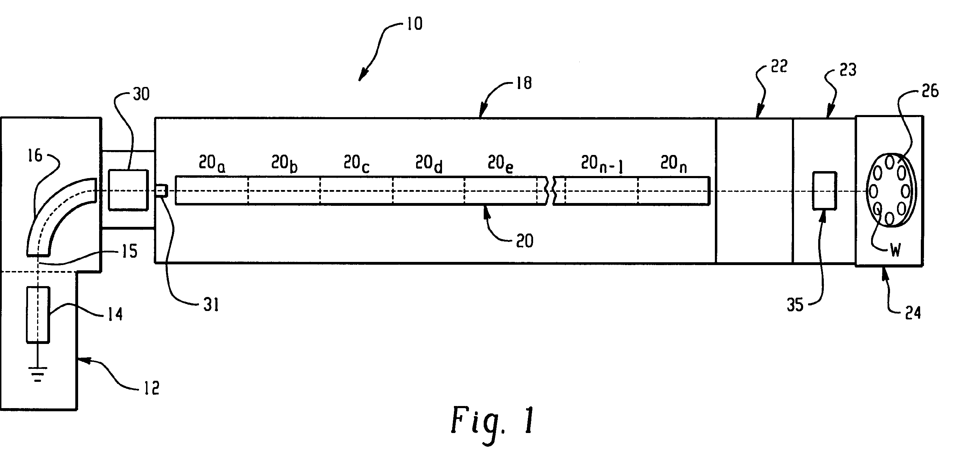

A cross sectional plan view of a high-energy ion implanter 10 is shown in Figure 1. Although the invention is described herein as being incorporated into an accelerating electrode in the RF linac portion of a high-energy ion implanter, it is understood that the invention may be incorporated into ion implanter components other than electrodes, and in ion implanter types other than high-energy. The invention is useful in any application wherein a reduction in x-ray emissions is desired, which would otherwise be generated by stray high-energy electrons striking structural components of the implanter.

The implanter 10 comprises five sections or subsystems: an injector 12 including an ion source 14 for producing an ion beam 15 and a mass analysis magnet 16 for mass analyzing the ion beam; a radio frequency (RF) linear accelerator (linac) 18 including a plurality of resonator modules 20a-20n for accelerating the ion beam to a higher energy; a final energy magnet (FEM) 22 for performing final mass analysis of the accelerated ion beam; a resolver housing 23 for final resolution and conditioning of the ion beam; and an end station 24 which contains a rotating disc 26 carrying wafers W to be implanted by the ion beam.

Positioned after the mass analysis magnet 16 at the entrance to the linac 18 is a variable aperture 30 for controlling the amount of beam current passing into the linac. Immediately downstream of the aperture 30 is a first flag Faraday 31 for measuring the beam current out of the aperture 30 and into the linac 18. A second flag Faraday 35 is located in the resolver housing 23 for measuring the current of the ion beam prior to implanting into the wafer W.

The mass analysis magnet 16 functions to pass to the RF linac 18 only the ions generated by the ion source 14 having an appropriate charge-to-mass ratio. The mass analysis magnet is required because the ion source 14, in addition to generating ions of appropriate charge-to-mass ratio, also generates ions of greater or lesser charge-to-mass ratio than that desired. Ions having inappropriate charge-to-mass ratios are not suitable for implantation into the wafer.

The ion beam that passes through the mass analysis magnet 16 is typically comprised of a single isotope and enters the RF linac 18 which imparts additional energy to the ion beam passing therethrough. The RF linac produces particle accelerating fields which vary periodically with time, the phase of which may be adjusted to accommodate different atomic number particles as well as particles having different speeds. Each of the plurality of resonator modules 20 in the RF linac 18 functions to further accelerate ions beyond the energies they achieve from a previous module.

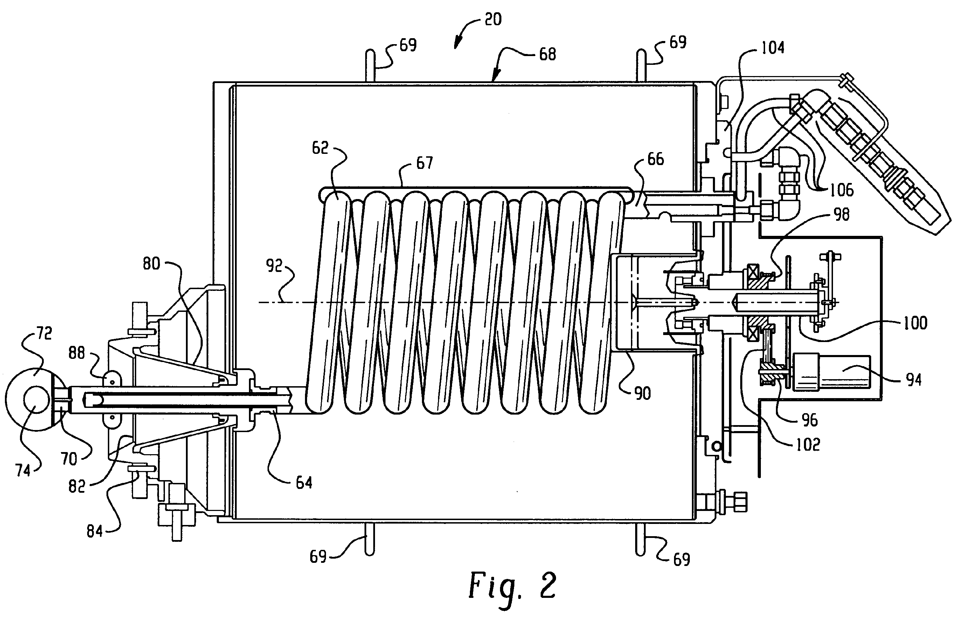

Figure 2 shows a known type of resonator module 20, comprising an inductor 62 formed by a coiled hollow copper tube. The high-voltage end of the coiled tube terminates in a first coil stem 64 and the low-voltage end of the coiled tube terminates in a second coil stem 66. A spacer 67 snaps into place over the individual coil loops of the inductor 62 to maintain the distance between coil loops (and hence the inductance of the coil), and to provide mechanical stability for the inductor. The coil resides in a cylindrical housing 68, in this case made of aluminum, which is electrically grounded during operation. Handles 69 are provided for removing and installing the resonator 60 from and into the system 10.

An RF input coupling (not visible in Figure 2) is provided to input an RF signal into the low-voltage end of the inductor 62. A cylindrical high-voltage accelerating electrode or drift tube 72 is attached to the high-voltage end of the inductor, at end 70 of the first coil stem 64. The drift tube 72 is fabricated of aluminum, and forms a passage 74 through which may pass an ion beam to be accelerated.

The resonator 60 is designed to resonate at the frequency of 13.56 megahertz (MHz). At resonance, a voltage greater than 20,000 volts (20 KV), and typically on the order of 80,000 volts (80 KV), is generated by the resonator at the accelerator electrode 72. As such, a ceramic insulating cone 80 extends from the grounded resonator housing toward the electrode to prevent arcing of between the housing and the electrode 72 or the high-voltage coil stem 64. An annular metal flange 82 is attached to the electrically grounded housing by fasteners 84 to secure the position of the insulating cone 80.

The mechanism for tuning the resonator 60 is provided by a metallic split ring clamp 88 located on the high-voltage stem 64 of the resonator coil, and a plunger 90 which is adapted to move in and out of the coil along its central longitudinal axis 92. A servomotor 94 functions to bidirectionally move the plunger along axis 92. A pulley 96 on the servomotor shaft is connected to a pulley 98 on the plunger shaft 100 via belt 102. Threads on the inside of the plunger shaft pulley 98 mate with threads on the outside of the plunger shaft 100 to convert rotational motion of the pulley 98 to linear movement of the shaft 100 along axis 92.

The low-voltage, high-current coil stem 66 and the plunger shaft 100 pass through a generally circular shaped aluminum end plate 104 which closes one end of the aluminum cylindrical housing 68. Because of the high current that passes through the coil at this end, heat is generated during operation of the resonator. As such, water-cooling means 106 are provided in the present invention for cooling the end plate 104, the plunger 90, and the coil 62.

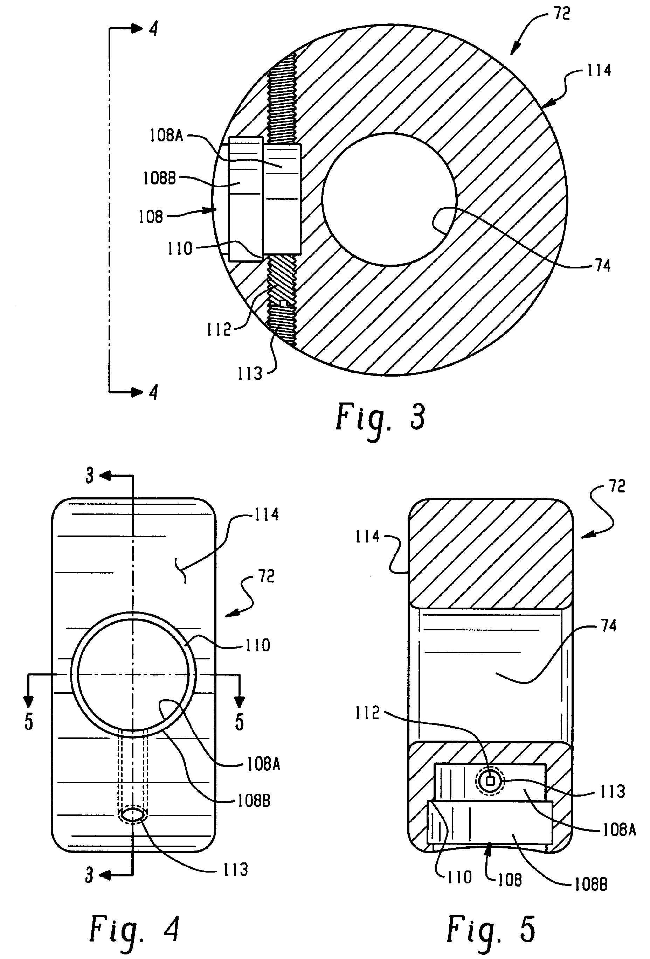

Figures 3 through 5 shows the accelerating electrode 72 in greater detail. According the present invention, x-ray emissions, that would otherwise result from stray electrons striking the accelerating electrode 72, are minimized by coating the electrode with a synthetic diamond or diamond-like material. The type of electrode shown is merely one type of electrode used on resonator modules in RF linacs, and is merely shown as one example. In addition, it is contemplated that the synthetic diamond or diamond-like material may be used to coat other portions of an ion implanter exposed to the ion beam.

As shown in Figures 3-5, the aluminum electrode 72 includes an RF coupling bore 108 for receiving high voltage end 70 of the first copper coil stem 64. The bore 108 comprises a inner bore 108A for receiving and seating coil stem end 70 and an outer bore 108B for receiving and seating an RF connector at ledge 110. The RF connector insures good electrical contact between the copper coil stem end 70 and the aluminum electrode 72. A setscrew 112 screwed into threaded bore 113 secures the copper coil stem end 70 within bore 108A.

A synthetic diamond or diamond-like coating (DLC) 114 is applied to the exposed exterior surface of the aluminum electrode 72 (but not the RF bore 108 or setscrew bore 113, which remain masked during the coating process). In the disclosed example, the diamond film has a thickness in the range of 2-10 microns (µm). The diamond or DLC is applied by known processes including chemical vapor deposition (CVD). The surface of the electrode may be roughened prior to the CVD process to facilitate adherence of the diamond or DLC to the electrode.

The diamond or DLC has a high thermal conductivity, and is very stable chemically. As such, little or no diamond material is sputtered from the electrode 72 during operation of the linac 18 that would otherwise be transported along with the ion beam 15. Thus, contamination problems that originate with the electrode are minimized.

In addition to the aluminum electrode 72, other components in the ion implanter beamline that are exposed to vacuum conditions may be coated to minimize production of x-rays during implanter operation. For example, other electrodes that accelerate (or decelerate) the ion beam, or beamline or process chamber walls, may be coated with the diamond or DLC. All that is necessary is that there be an underlying base structure which is capable of being coated with a diamond or DLC layer.

The DLC, which is an amorphous (hydrogenated) carbon material comprising a random covalent network of graphitic-type structures, resemble the properties of diamond.
The carbon component of the diamond or DLC helps minimize the production of x-rays, due to the dependence of the Bremsstrahlung radiation-generating process on the atomic mass of the target material. The carbon-based diamond or DLC, having less atomic mass than the underlying aluminum electrode, produces less radiation as a target than does the uncoated aluminum electrode. Accordingly, less shielding is required in the implanter enclosure.

Although the invention has been described in terms of diamond, or DLC, it is contemplated that other, low atomic number (*e.g.*, 6 or less) elements may be substituted. For example, coatings of lithium, beryllium or boron would also serve to minimize x-ray generation.

Accordingly, a preferred embodiment of the use of diamond or diamond-like coated components in an ion implanter for reducing x-ray emissions has been described. With the foregoing description in mind, however, it is understood that this description is made only by way of example, that the invention is not limited to the particular embodiments described herein, and that various rearrangements, modifications, and substitutions may be implemented with respect to the foregoing description without departing from the scope of the invention as defined by the following claims and their equivalents.

## Claims

1. A component of an ion implanter (10) for reducing x-ray emissions generated by the component when struck by electrons during operation of the implanter, comprising:
a base structure (72) providing a coatable surface; and
a coating (114) applied to said coatable surface of said base structure (72), said coating comprised of a material having as lesser atomic mass that that of the base structure, such that electrons impacting said coating produce less x-rays than electrons impacting said base structure.

2. The component of claim 1, wherein said base structure is an electrode (72) through which an ion beam (15) passes during operation of the ion implanter (10).

3. The component of claim 2, wherein said electrode is an accelerating electrode in a radio frequency (RF) linear accelerator (linac) (18).

4. The component of claim 3, wherein said electrode carries a voltage of at least 20,000 volts (20 KV).

5. The component of claim 4, wherein said electrode carries a voltage of approximately 80,000 volts (80 KV).

6. The component of claim 3, wherein said coating is comprised of an element having an atomic number of less than six.

7. The component of claim 3, wherein said coating (114) is a carbon-based material.

8. The component of claim 7, wherein said coating (114) is a synthetic diamond or diamond-like coating (DLC) material.

9. The component of claim 8, wherein said base structure (72) is comprised of aluminum.

10. The component of claim 8, wherein said coating (114) has a thickness of approximately two to ten (2-10) microns (µm).

11. The component of claim 10, wherein said coating (114) is applied to said base structure (72) by a chemical vapor deposition (CVD) process.

12. A method of operating an ion implanter (10), comprising the steps of:
generating an ion beam (15) with an ion source (14); and
passing the ion beam (15) through an accelerating electrode (72) in a radio frequency (RF) linear accelerator (linac) (18), said electrode comprising a coatable base structure and a coating (114) applied thereto, said coating comprised of a material having as lesser atomic mass that that of the base structure, such that electrons impacting said coating produce less x-rays than electrons impacting said base structure;

13. The method of claim 12, wherein said electrode carries a voltage of at least 20,000 volts (20 KV).

14. The method of claim 13, wherein said electrode carries a voltage of approximately 80,000 volts (80 KV).

15. The method of claim 12, wherein said coating (114) is comprised of an element having an atomic number of less than six.

16. The method of claim 12, wherein said coating (114) is a carbon-based material.

17. The method of claim 16, wherein said coating (114) is a synthetic diamond or diamond-like coating (DLC) material.

18. The method of claim 17, wherein said coating (114) has a thickness of approximately two to ten (2-10) microns (µm).
